# FASCICULE DE BREVET EUROPEEN

(11) **EP 0 506 186 B1**
(45) Date de publication et mention de la délivrance du brevet: **07.12.1994**
(21) Numéro de dépôt: 92200802.4
(22) Date de dépôt: 20.03.1992
(51) Int. Cl.: H03F 1/02, H03F 3/19, H04N 5/14

(54) **Dispositif amplificateur vidéo**
Videoverstärkervorrichtung
Video amplifier device

(30) Priorité: 29.03.1991 FR 9103852
(43) Date de publication de la demande: 30.09.1992
(73) Titulaire: PHILIPS ELECTRONIQUE GRAND PUBLIC, 92150 Suresnes (FR); Philips Electronics N.V., 5621 BA Eindhoven (NL)
(72) Inventeur: Vilard, Philippe, F-75008 Paris (FR)
(74) Mandataire: Caron, Jean

(56) Documents cités:
- DE-A- 2 840 822
- GB-A- 2 084 418
- US-A- 4 118 731

## Description

La présente invention concerne un dispositif amplificateur video pour un tube image de télévision, comprenant un transistor amplificateur dont le collecteur est relié à une extrémité d'une impédance de charge dont l'autre extrémité est reliée à une source d'alimentation, le signal de sortie de l'amplificateur étant prélevé sur ledit collecteur qui est connecté à une électrode de commande video du tube image. Le document US-A- 4 118 731 donne un exemple d'un tel dispositif.

Avec de tels dispositifs amplificateurs, on rencontre le problème suivant : si l'impédance de charge du transistor amplificateur est faible, cela conduit à un courant important dans le transistor avec une grande dissipation de puissance, et si cette impédance de charge est grande la bande passante de l'amplificateur est insuffisante.

Ce problème peut être résolu en remplaçant la charge par un élément actif, par exemple un deuxième transistor amplificateur de polarité opposée au premier. Une telle solution utilisant deux montages cascode en push-pull complémentaire est décrite par exemple dans les documents US-A-4 727 336, US-A-4 035 840, ou JP-A-63 26105.

Néanmoins, avec cette solution la réalisation de la commande du deuxième transistor amplificateur est délicate, car si l'on utilise une capacité de liaison (documents US-A-4 035 840 et JP-A-63 26105) cela oblige à un compromis sur la fréquence de transition de la liaison capacitive, et si l'on utilise une commande qui transmet la composante continue, cela complique la réalisation à cause du décalage en tension continue entre les bases des deux transistors (par exemple le circuit du document US-A-4 727 336 comporte de ce fait deux alimentations : +55V et -55V).

L'invention selon la revendication 1 se propose de fournir un dispositif plus simple et dont les performances sont supérieures à celles d'un dispositif muni d'une charge passive, ce qui procure l'avantage subsidiaire que l'on peut abaisser la valeur de la tension d'alimentation.

A cet effet, dans le dispositif selon l'invention, ladite impédance de charge est un générateur de courant et il comporte un dispositif de régulation dudit courant en fonction du niveau de tension sur le collecteur du transistor amplificateur, agissant de façon telle que ledit courant diminue lorsque ladite tension augmente, avec une constante de temps plus grande que la période la plus grande des signaux video.

Avantageusement, la constante de temps est de l'ordre de grandeur de la période de récurrence de trame du téléviseur.

Dans une variante, la composante alternative du signal de sortie est redressée et est ajoutée en partie à la commande de régulation du générateur de courant.

Selon un mode particulier de réalisation de l'invention où le transistor amplificateur est de type NPN et l'alimentation est positive, ledit générateur de courant est un transistor PNP dont l'émetteur est relié à l'alimentation, dont le collecteur est relié à celui du transistor amplificateur, et dont la base est reliée par une résistance à la sortie de l'amplificateur, des moyens de polarisation constante de la base de ce transistor PNP, munis d'une capacité de découplage à la masse, étant prévus par ailleurs.

Selon une variante de ce mode de réalisation, la composante alternative du signal de sortie est redressée et est ajoutée en partie à la polarisation du transistor PNP générateur de courant, au moyen d'un montage fait d'une capacité reliée d'un coté au collecteur du transistor amplificateur et de l'autre coté avec l'anode d'une diode de signal dont la cathode est reliée à une prise intermédiaire de la résistance, l'anode de la diode étant aussi reliée par une résistance à la base du transistor PNP générateur de courant.

La description qui va suivre, en regard du dessin annexé décrivant un exemple non limitatif fera bien comprendre comment l'invention peut être réalisée.

La figure unique représente un dispositif selon l'invention.

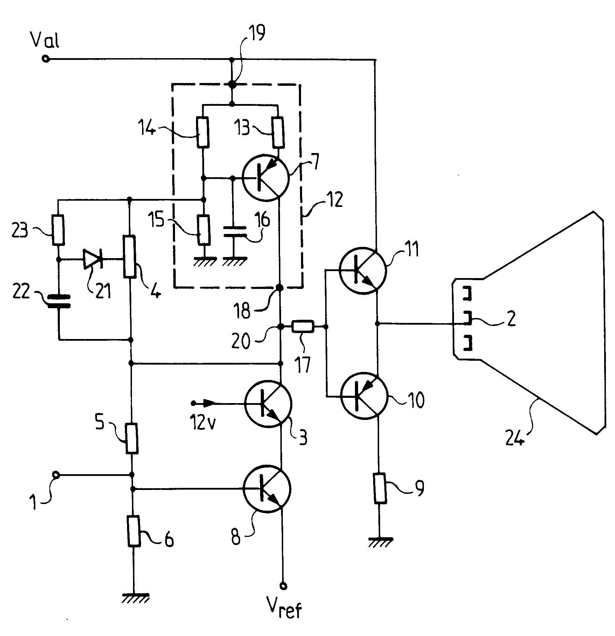

Le dispositif de la figure 1 est muni d'une borne d'entrée 1 à laquelle est appliqué un signal video qui doit être amplifié pour être appliqué à une électrode de commande video 2, par exemple une cathode, d'un tube image 24.

Le signal sur la borne d'entrée 1 attaque la base d'un transistor NPN 8 de type BC548, monté en émetteur commun, dont l'émetteur est relié à une source de tension de référence continue Vref, et dont le collecteur est relié à l'emetteur d'un transistor NPN amplificateur 3 de type BF422, monté en base commune. La base du transistor 3 est reliée à une source de tension continue de 12 volts, et son collecteur est relié à une extrémité 18 d'une impédance de charge 12 dont l'autre extrémité 19 est reliée à une source d'alimentation Val. L'ensemble des transistors 8 et 3 constitue ainsi ce qu'on appelle un montage cascode. La base du transistor 8 est polarisée au moyen d'une résistance 5 de contre-réaction de 120 kilo-ohms reliée au collecteur du transistor 3, et d'une résistance 6 de 2,7 kilo-ohms reliée à la masse.

Le signal de sortie de l'amplificateur est prélevé sur la connexion de collecteur 20 du transistor 3 , et transmis à l'électrode 2 du tube image via une résistance 17 de 330 ohms et un étage en push-pull de transistors 10 et 11 complémentaires, respectivement de types BF423 et BF422, montés chacun en émetteur-suiveur, ce qui permet notamment la mesure du courant de faisceau du tube image dans une résistance 9 à des fins de régulation de "cut-off" ou de blanc qui ne font pas partie de l'invention. La présence de cet étage ne modifie pas grand chose au problème posé, car la capacité d'entrée des transistors 10, 11 est du même ordre de grandeur que la capcité d'electrode de tube image, et le transistor 3 "voit" à peu près la même impédance que s'il était relié directement à l'électrode 2.

L'impédance de charge 12 est un générateur de courant et est constituée principalement par un transistor PNP 7 de type BF423 constituant une source de courant. Son collecteur est relié à celui du transistor amplificateur 3. L'émetteur de ce transistor PNP 7 est relié, via une résistance 13 de 2200 ohms, à la source d'alimentation Val qui est une alimentation positive de 150 à 170 volts (alors que 200 volts seraient nécessaires avec une charge résistive simple).

Le transistor 7 générateur de courant est commandé par un dispositif de régulation de courant. Des moyens de polarisation constante de la base de ce transistor sont constitués d'une résistance 14 de 100 kilo-ohms et d'une résistance 15 de 2,2 mégohms reliant la base du transistor 7 respectivement à l'alimentation et à la masse, avec une capacité 16 de 10 nanofarads qui assure le découplage à la masse de la base du transistor. Enfin une résistance 4 de 430 kilo-ohms relie la base du transistor 7 au collecteur du transistor 3 (constituant la sortie 20 de l'amplificateur). Il est clair que si la tension moyenne au point 20 par exemple augmente, la tension aux bornes de la résistance 4 diminue : il y passe moins de courant et le transistor 7 conduit donc lui aussi moins de courant. La régulation agit donc en fonction du niveau de tension sur le collecteur du transistor 3, de façon telle que ledit courant diminue lorsque ladite tension augmente. La constante de temps de la régulation est le produit de la valeur des trois résistances 4, 14, 15 en parallèle et de la valeur de la capacité 16. Elle est plus grande que la période la plus grande des signaux video, et est de l'ordre de grandeur de la période de récurrence de trame du téléviseur.

Avec une charge statique (résistive) la puissance dissipée dans le transistor amplificateur est maximale lorsque la tension de sortie est la moitié de la tension d'alimentation. Avec une charge faite d'une source de courant fixe, la puissance dissipée dans le transistor amplificateur est maximale lorsque la tension de sortie est la plus proche de la tension d'alimentation. Dans un cas comme dans l'autre, pour les valeurs de tension telles que la puissance n'est pas la puissance maximale, la bande passante est réduite par rapport à ce qui serait possible avec la puissance maximale que le transistor est capable de dissiper sans danger. Avec le dispositif de l'invention, la régulation du courant peut être ajustée de telle façon que la puissance dissipée dans le transistor amplificateur est constante quelle que soit la tension moyenne de sortie, et par conséquent la bande passante est toujours optimale.

Il est en outre possible de faire varier aussi le courant du générateur de courant en fonction de l'amplitude de la tension alternative du signal de sortie. Cela peut être obtenu en redressant cette tension et en l'ajoutant en partie à la polarisation du transistor PNP 7 générateur de courant, par exemple au moyen d'un montage fait d'une capacité 22 de quelques picofarads reliée d'un coté au collecteur 20 du transistor amplificateur et de l'autre coté à l'anode d'une diode de signal 21 de type 1N4148 dont la cathode est reliée à une prise intermédiaire de la résistance 4, l'anode de la diode 21 étant aussi reliée par une résistance 23 à la base du transistor PNP 7 générateur de courant. La position de la prise intermédiaire dans la résistance 4 peut être déterminée facilement de façon expérimentale, selon l'effet désiré. Toutefois cette variante avec le montage redresseur constitué par les éléments 21-23 est d'un intérêt mineur.

Moyennant des dispositions particulières, la tension d'alimentation peut encore être abaissée. Supposons par exemple que le niveau du noir est obtenu pour une tension cathode-grille de 150 volts. En reliant la grille du tube image à une source de tension négative, par exemple une source de -30 volts qui peut exister déja dans le téléviseur, on obtient alors une tension absolue de cathode, pour le noir, qui est de seulement 120 volts, et on peut abaisser la tension d'alimentation de l'amplificateur video jusqu'à 150 volts et profiter alors de tensions d'alimentation de ce niveau déja existantes.

Avec les éléments indiqués dans l'exemple décrit ci-dessus mais avec une charge résistive fixe pour le transistor 3, on était obligé avant l'invention d'utiliser deux transistors 3 de type BF422 en parallèle, avec des organes refroidisseurs appelés "radiateurs", afin de supporter la puissance nécessaire pour obtenir la bande passante ; avec le montage selon l'invention et grâce notamment à la réduction de tension d'alimentation, un seul transistor est suffisant.

Bien entendu les valeurs numériques ou bien les références de semiconducteurs indiquées dans la description ci-dessus n'ont qu'une valeur documentaire, et ne doivent pas être considérées comme nécessaires, quoiqu'elles aient permis à la demanderesse de réaliser un dispositif satisfaisant. Par exemple le générateur de courant 12 pourrait être réalisé de manière différente, des circuits générateurs de courant commandable existant dans le commerce notamment sous forme de circuit intégré.

## Revendications

1. Dispositif amplificateur video pour un tube image de télévision (24), comprenant un transistor amplificateur (8,3) dont le collecteur (3) est relié à une extrémité d'une impédance (18) de charge dont l'autre extrémité est reliée à une source d'alimentation (19), le signal de sortie de l'amplificateur étant prélevé sur ledit collecteur (20) qui est connecté à une électrode de commande video du tube image (2), caractérisé en ce que ladite impédance de charge est un générateur de courant (12) et en ce qu'il comporte un dispositif de régulation dudit courant (4, 21, 22, 23) en fonction du niveau de tension sur le collecteur du transistor (3), agissant de façon telle que ledit courant diminue lorsque ladite tension augmente, avec une constante de temps plus grande que la période la plus grande des signaux video.

2. Dispositif amplificateur video selon la revendication 1, caractérisé en ce que la constante de temps est de l'ordre de grandeur de la période de récurrence de trame du téléviseur.

3. Dispositif selon l'une des revendications 1 ou 2, caractérisé en ce que la composante alternative du signal de sortie est redressée et est ajoutée en partie à la commande de régulation du générateur de courant.

4. Dispositif selon l'une quelconque des revendications 1 à 3, dans lequel le transistor amplificateur est de type NPN (3, 8) et l'alimentation est positive, caractérisé en ce que ledit générateur de courant est un transistor PNP (7) dont l'émetteur est relié à l'alimentation, dont le collecteur est relié à celui du transistor amplificateur, et dont la base est reliée par une résistance (4) à la sortie de l'amplificateur, des moyens de polarisation constante (14,15) de la base de ce transistor PNP, munis d'une capacité de découplage à la masse (16), étant prévus par ailleurs.

5. Dispositif selon la revendication 4, caractérisé en ce que la composante alternative du signal de sortie est redressée et est ajoutée en partie à la polarisation du transistor PNP générateur de courant, au moyen d'un montage fait d'une capacité (22) reliée d'un coté au collecteur du transistor amplificateur (3) et de l'autre coté avec l'anode d'une diode de signal (21) dont la cathode est reliée à une prise intermédiaire de la résistance (4), l'anode de la diode étant aussi reliée par une résistance (23) à la base du transistor PNP générateur de courant.

## Patentansprüche

1. Videoverstärkervorrichtung für eine Fernsehbildröhre (24) mit einem Verstärkertransistor (8,3), dessen Kollektor (20) mit einem Ende (18) einer Lastimpedanz verbunden ist, deren anderes Ende (19) an eine Speisespannung (Val) angeschlossen ist, wobei das Ausgangssignal des Verstärkers an dem mit einer Videosteuerelektrode der Bildröhre verbundenen Kollektor (20) abgegriffen wird, dadurch gekennzeichnet, daß die Lastimpedanz aus einem Stromgenerator (12) besteht und eine Vorrichtung (4, 12) zur Regelung des Stroms in Abhängigkeit von der Spannung am Kollektor (20) des Verstärkertransistors (3) umfaßt derart, daß der Strom sich bei steigender Spannung verringert, wobei die Zeitkonstante größer ist als die größte Periode der Videosignale.

2. Vorrichtung nach Anspruch 1, dadurch gekennzeichnet, daß die Zeitkonstante in der Größenordnung der Halbbild-Wiederholperiode des Fernsehers liegt.

3. Vorrichtung nach Anspruch 1 oder 2, dadurch gekennzeichnet, daß die Wechselspannungskomponente des Ausgangssignals gleichgerichtet und teilweise der Regeisteuerung des Stromgenerators zugeführt wird.

4. Vorrichtung nach einem der Ansprüche 1 bis 3, bei der der Verstärkertransistor ein NPN-Transistor (3) und die Speisespannung positiv ist, dadurch gekennzeichnet, daß der Stromgenerator aus einem PNP-Transistor (3) besteht, dessen Emitter mit der Speisespannung, dessen Kollektor mit dem Kollektor des Verstärkertransistors (3) und dessen Basis über einen Widerstand (4) mit dem Ausgang des Verstärkers verbunden ist, wobei im übrigen mit einer Masse-Entkopplungskapazität ausgestattete Mittel (14, 15) zur konstanten Polarisierung der Basis dieses PNP-Transistors vorgesehen sind.

5. Vorrichtung nach Anspruch 4, dadurch gekennzeichnet, daß die Gleichspannungskomponente des Ausgangssignals gleichgerichtet und über eine Anordnung, die aus einer Kapazität (22) besteht, die einerseits mit dem Kollektor (20) des Verstärkertransistors (3) und andererseits mit der Anode einer Signaldiode (21) verbunden ist, deren Kathode mit einer Zwischenanzapfung des Widerstandes (14) verbunden ist, teilweise der Polarisation des als Stromgenerator dienenden PNP-Transistors zugeführt wird, wobei die Anode der Diode auch über einen Widerstand (23) mit der Basis des als Stromgenerator dienenden PNP-Transistors verbunden ist.

## Claims

1. A video amplifier arrangement for a television display tube (24), comprising an amplifier transistor (8,3) whose collector (20) is coupled to a terminal (18) of a load impedance, the other terminal (19) of which is coupled to a power supply source (val), the output signal of the amplifier being taken from said collector (20) which is coupled to a video control electrode (2) of the display tube, characterized in that said load impedance is a current generator (12) and in that it comprises a device for controlling said current (4, 12) as a function of the voltage level (20) at the collector of the amplifier transistor (3), said control acting in such a way that said current decreases when said voltage increases with a time constant which is larger than the largest period of the video signals.

2. A video amplifier arrangement as claimed in Claim 1, characterized in that the time constant is of the order of the field retrace period.

3. An arrangement as claimed in Claim 1 or 2, characterized in that the ac component of the output signal is rectified and is partly applied to the drive for controlling the current generator.

4. An arrangement as claimed in any one of Claims 1 to 3, in which the amplifier transistor is of the NPN type (3) and the power supply is positive, characterized in that said current generator is a PNP transistor (7) whose emitter is coupled to the power supply, the collector is coupled to that of the amplifier transistor (3) and the base is coupled to the output of the amplifier via a resistor (4), while means (14, 15) are provided for a bias setting of the base of said PNP transistor, which means include a grounded decoupling capacitor (16).

5. An arrangement as claimed in Claim 4, characterized in that the ac component of the output signal is rectified and is partly applied to the bias setting of the current generator PNP transistor by means of a circuit comprising a capacitor (22) which is coupled at one end to the collector (20) of the amplifier transistor (3) and at the other end to the anode of a signal diode (21) whose cathode is coupled to a central tap of the resistor (4), the anode of the diode being also coupled to the base of the current generator PNP transistor via a resistor (23).
